(19) Europäisches Patentamt
European Patent Office
Office européen des brevets

(11) **EP 3 916 400 B1**

(12) **FASCICULE DE BREVET EUROPEEN**

(45) Date de publication et mention de la délivrance du brevet:
**04.10.2023 Bulletin 2023/40**

(21) Numéro de dépôt: **21166070.9**

(22) Date de dépôt: **30.03.2021**

(51) Classification Internationale des Brevets (IPC):
**G01R 19/165** (2006.01)  **G01R 19/32** (2006.01)
**H02H 3/08** (2006.01)  **H02H 7/122** (2006.01)
**H03K 17/082** (2006.01)

(52) Classification Coopérative des Brevets (CPC):
**G01R 19/16571; G01R 19/32; H03K 17/0822;**
H03K 2217/0027

(54) **PROCEDE DE COMPENSATION DE TEMPERATURE DANS UN DISPOSITIF DE MESURE DE COURANT ET DISPOSITIF DE MESURE DE COURANT ASSOCIE**

VERFAHREN ZUR TEMPERATURKOMPENSATION IN EINER STROMMESSVORRICHTUNG UND ENTSPRECHENDE STROMMESSVORRICHTUNG

METHOD OF TEMPERATURE COMPENSATION IN A CURRENT MEASURING DEVICE AND ASSOCIATED CURRENT MEASURING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.04.2020 FR 2003937**

(43) Date de publication de la demande:
**01.12.2021 Bulletin 2021/48**

(73) Titulaire: **NEXTER Systems**
**78034 Versailles Cedex (FR)**

(72) Inventeur: **DECROUX, Philippe**
**18023 BOURGES (FR)**

(74) Mandataire: **Cabinet Chaillot**
**16/20, avenue de l'Agent Sarre**
**B.P. 74**
**92703 Colombes Cedex (FR)**

(56) Documents cités:
**EP-A1- 3 086 131**    **JP-A- 2003 042 870**
**JP-A- 2012 154 829**    **US-A- 6 028 426**
**US-A1- 2006 255 858**    **US-A1- 2011 089 931**
**US-A1- 2013 257 517**    **US-A1- 2017 059 632**
**US-A1- 2019 238 124**    **US-B2- 6 724 202**

**Description**

La présente invention concerne le domaine des dispositifs de mesure de courant dans un circuit électrique, et porte en particulier sur un procédé de compensation de température dans un dispositif de mesure de courant et sur un dispositif de mesure de courant associé.

Il est connu de réaliser une mesure de courant dans un circuit électrique en utilisant la résistance interne $R_{ON}$ d'un composant de puissance (tel qu'un transistor MOS) à l'état passant comme shunt, la tension aux bornes du composant de puissance étant fonction du courant.

Cette solution présente cependant comme inconvénient que la résistance interne $R_{on}$ du composant de puissance est dépendante de la température. Il en résulte une erreur sur la mesure de l'intensité.

Afin d'améliorer la précision de mesure, une compensation thermique de la mesure a été intégrée dans le dispositif de mesure de courant divulgué dans la demande de brevet français FR3034873A1 (ou la demande de brevet européen EP3086131A1 correspondante), ledit dispositif de mesure de courant comprenant un composant de puissance, un étage amplificateur et un calculateur. Cette correction est réalisée à l'aide d'une résistance variable numérique pilotée par le calculateur, tel qu'un microprocesseur, sur la base de la connaissance de la température du composant de puissance mesurée à l'aide d'un capteur de température. Sur la base de la valeur de la température du composant de puissance, l'algorithme du calculateur calcule la valeur de résistance variable numérique à appliquer pour maintenir le rapport Vs/($R_{on}$.I) constant sur toute la plage de températures d'utilisation du circuit, où Vs est la tension de sortie de l'étage amplificateur et I est le courant aux bornes du composant de puissance. Pour maintenir constant ce rapport, la loi de variation de $R_{on}$ en fonction de la température est modélisée par une équation du type $R_{on} = a.T^2 + b.T + c$, avec T la température du composant de puissance, et a, b et c des constantes relatives au composant de puissance.

Cependant, il existe une limitation liée à la thermique du composant de puissance. En effet, la précision de la mesure est fortement liée au couplage thermique entre la ou les puces du composant de puissance et le capteur de température. Le composant de puissance et le capteur de température sont, en effet, tous les deux montés sur un même support, le capteur de température étant monté à une certaine distance du composant de puissance, ce qui peut induire un écart de température entre le composant de puissance et le capteur de température.

Dans la pratique, tant que le courant est inférieur au quart du courant maximal du composant de puissance (par exemple, transistor MOS), le couplage thermique est réalisé dans de bonnes conditions si le support est un SMI (substrat métallique isolé).

Pour les courants supérieurs, la résistance thermique entre la puce du composant de puissance et le support induit un écart de température qui fausse le couplage thermique. Cet écart a pour conséquence une sous-estimation de la température du composant de puissance. De ce fait, l'estimation de la résistance interne $R_{on}$ du composant de puissance est sous-estimée, et donc le courant estimé par le dispositif de mesure de courant est majoré. Il en résulte une erreur sur la mesure de l'intensité. Il a ainsi été constaté lors d'une expérimentation que l'erreur de mesure était croissante en fonction de la valeur du courant et pouvait être proche d'un polynôme du deuxième ordre à partir d'une certaine valeur de courant (400 Ampères dans ladite expérimentation).

La demande de brevet japonais JP2012154829A décrit un montage permettant de corriger le coefficient de sensibilité à la température d'un capteur. Cependant, ce montage se limite à diminuer la sensibilité à la température du capteur, mais ne permet pas d'apporter une correction effective de la température mesurée.

La présente invention vise à résoudre les inconvénients de l'état antérieur de la technique, en proposant un procédé de compensation de température dans un dispositif de mesure de courant comprenant un composant de puissance, un étage amplificateur et un calculateur, dans lequel la variation de température du composant de puissance en fonction de la valeur du courant aux bornes du composant de puissance est prise en compte et compensée lors du réglage du gain de l'étage amplificateur de manière à réaliser une compensation de température plus précise.

La présente invention a donc pour objet un procédé de compensation de température dans un dispositif de mesure de courant comprenant : un composant de puissance configuré pour être incorporé en série dans un circuit électrique de puissance et possédant une résistance interne $R_{on}$ à l'état passant ; un étage amplificateur dont l'entrée est reliée à l'une des bornes du composant de puissance, l'étage amplificateur étant configuré de telle sorte que la tension de sortie $V_s$ de l'étage amplificateur est fonction du courant I aux bornes du composant de puissance, l'étage amplificateur comprenant un amplificateur opérationnel associé à un circuit de réglage de gain ; et un calculateur couplé à un capteur de température configuré pour mesurer la température du composant de puissance et à une résistance variable numérique $R_v$ du circuit de réglage de gain de l'étage amplificateur, caractérisé par le fait que le calculateur est configuré pour réaliser les étapes suivantes de manière itérative : recevoir une valeur de température mesurée en provenance du capteur de température ; corriger la valeur de température mesurée en fonction de la tension de sortie $V_s$ de l'étage amplificateur, suivant une première loi ou table incorporée dans le calculateur ; calculer la valeur de la résistance interne $R_{on}$ du composant de puissance en fonction de la valeur de température corrigée, suivant une deuxième loi ou table incorporée dans le calculateur ; calculer la valeur de résistance à appliquer à la résistance variable numérique $R_v$ en fonction de la valeur de $R_{on}$ calculée, suivant une troisième loi ou table incorporée dans le calculateur, de façon à ce que le rapport K = Vs/I soit constant sur toute la plage de températures d'utilisation du circuit électrique ; et appliquer la valeur de résistance calculée à la résistance variable numérique $R_v$. Ainsi, la variation de température du composant de puissance en fonction de la valeur du courant aux bornes du composant de puissance est prise en compte et compensée lors du réglage du gain de l'étage amplificateur à l'aide de la résistance variable numérique, de manière à réaliser une compensation de température plus précise.

L'écart de température entre le composant de puissance et son support dans le cas où un fort courant traverse le composant de puissance est ainsi compensé à l'aide de la première loi ou table incorporée dans le calculateur, ce qui permet de ne pas sous-estimer la température du composant de puissance, et ainsi de ne pas surestimer le courant traversant le composant de puissance.

Le procédé selon la présente invention permet ainsi de mesurer l'intensité circulant dans le composant de puissance sans perturbations dues aux variations de température du composant.

A titre d'exemple, le procédé selon la présente invention permet de minimiser l'erreur sur la mesure de courant à moins de 1%.

Selon une première variante de l'invention, la première loi est la suivante : $T_{corrigée} = T_{mesurée} + (e.I^2 + f) = T_{mesurée} + (e.(V_s/K)^2 + f)$ , où $T_{corrigée}$ est la valeur de température corrigée, $T_{mesurée}$ est la valeur de température mesurée par le capteur de température, I est le courant aux bornes du composant de puissance, e et f sont des constantes prédéfinies relatives au composant de puissance et à son montage.

Ainsi, l'augmentation de la température de la puce du composant de puissance par rapport à celle de son support en fonction du courant traversant le composant de puissance est modélisée à l'aide de la première loi ci-dessus.

Selon une seconde variante de l'invention, la première loi est la suivante : $T_{corrigée} = T_{mesurée} + [(e.I^2 + f).(1 - e^{(-t/\tau)})] = [(e.(V_s/K)^2 + f).(1 - e^{(-t/\tau)})]$, où $T_{corrigée}$ est la valeur de température corrigée, $T_{mesurée}$ est la valeur de température mesurée par le capteur de température, I est le courant aux bornes du composant de puissance, e et f sont des constantes prédéfinies relatives au composant de puissance et à son montage, t représente le temps, et $\tau$ est la constante de temps thermique du dispositif.

L'impédance thermique située entre la puce du composant de puissance et son support est constituée d'une résistance thermique en parallèle avec une capacité thermique afin de traduire l'inertie thermique.

Dans cette seconde variante, la modélisation est complétée, par rapport à celle de la première variante, par ajout d'un système du premier ordre, de manière à prendre en compte l'évolution de l'erreur de mesure dans le temps.

Selon une caractéristique particulière de l'invention, la deuxième loi est la suivante : $R_{on} = a.T_{corrigée}^2 + b.T_{corrigée} + c$, où $R_{on}$ est la valeur calculée de la résistance interne à l'état passant du composant de puissance, $T_{corrigée}$ est la valeur de température corrigée, et a, b et c sont des constantes prédéfinies relatives au composant de puissance. Ainsi, la variation de $R_{on}$ en fonction de la température du composant de puissance est modélisée sous la forme de la fonction polynomiale ci-dessus.

Selon une caractéristique particulière de l'invention, le circuit de réglage de gain comprend la résistance variable numérique $R_v$, une première résistance R1 disposée entre la résistance variable numérique $R_v$ et l'entrée inverseuse de l'amplificateur opérationnel, et une seconde résistance R2 disposée entre l'entrée inverseuse et la sortie de l'amplificateur opérationnel, la troisième loi étant la suivante : $R_v = (R1 + R2 - K.R1/R_{on}).[R_{on}/(K-R_{on})]$.

Selon une caractéristique particulière de l'invention, la tension de sortie $V_s$ analogique de l'étage amplificateur est convertie en une valeur numérique $V_\mu$ par le calculateur auquel la tension de sortie $V_s$ est appliquée par l'intermédiaire d'un pont diviseur formé de deux résistances R3 et R4, la tension $V_\mu$ numérique convertie par un convertisseur analogique/numérique incorporé au calculateur étant ainsi égale à : $V_\mu = V_s.[R4/(R4 + R3)].[2^n/V_{ref}]$, où $V_{ref}$ est la tension de référence du convertisseur analogique/numérique, et n est la résolution de ce convertisseur.

La présente invention a en outre pour objet un dispositif de mesure de courant comprenant un composant de puissance configuré pour être incorporé en série dans un circuit électrique de puissance et possédant une résistance interne $R_{on}$ à l'état passant ; un étage amplificateur dont l'entrée est reliée à l'une des bornes du composant de puissance, l'étage amplificateur étant configuré de telle sorte que la tension de sortie $V_s$ de l'étage amplificateur est fonction du courant I aux bornes du composant de puissance, l'étage amplificateur comprenant un amplificateur opérationnel associé à un circuit de réglage de gain ; et un calculateur couplé à un capteur de température configuré pour mesurer la température du composant de puissance et à une résistance variable numérique $R_v$ du circuit de réglage de gain de l'étage amplificateur, le calculateur étant configuré pour mettre en oeuvre le procédé de compensation de température tel que décrit ci-dessus.

Selon une caractéristique particulière de l'invention, le composant de puissance est l'un parmi un transistor MOS, un transistor bipolaire et un transistor bipolaire à grille isolée (IGBT).

Selon une caractéristique particulière de l'invention, le dispositif de mesure de courant comprend en outre un circuit comparateur auquel est appliquée la tension de sortie $V_s$ de l'étage amplificateur, ledit circuit comparateur étant configuré pour provoquer l'ouverture du circuit électrique de puissance dans lequel le courant I circule lorsque la tension de sortie $V_s$ dépasse un seuil prédéfini $V_L$.

Pour mieux illustrer l'objet de la présente invention, on va en décrire ci-après, à titre illustratif et non limitatif, un mode de réalisation préféré, avec référence aux dessins annexés.

Sur ces dessins :

> [Fig. 1] est un schéma simplifié d'un dispositif de mesure de courant selon la présente invention ; et
> [Fig. 2] est une courbe montrant l'erreur de mesure de courant au cours du temps avec ou sans le procédé de compensation de température selon la présente invention.

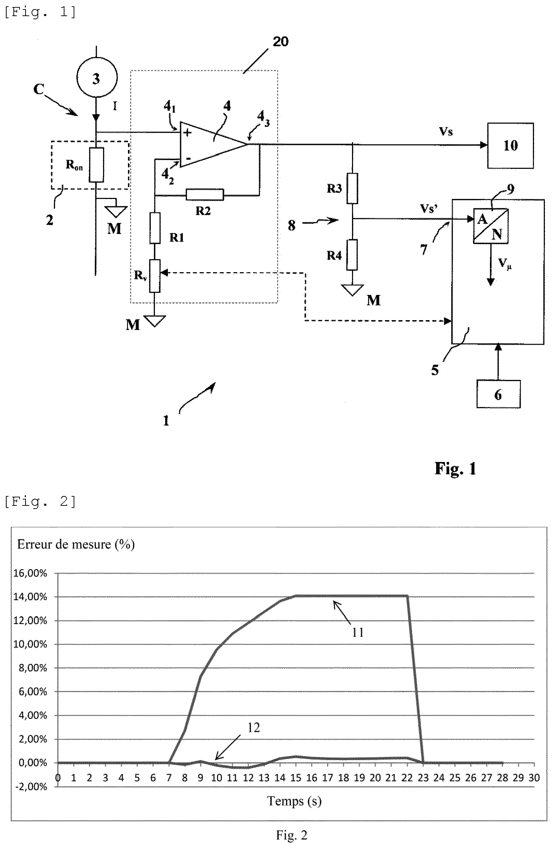

Si l'on se réfère à la Figure 1, on peut voir qu'il y est représenté un dispositif de mesure de courant 1 selon la présente invention.

Le dispositif de mesure 1 du courant circulant dans un circuit électrique de puissance C, réalise la mesure du courant I qui circule dans un composant de puissance 2 (par exemple, un transistor MOSFET, plus communément désigné transistor MOS) incorporé en série dans le circuit électrique de puissance C. Un tel composant de puissance 2 de type transistor MOS est, par exemple, un contacteur statique à semi-conducteurs d'un circuit alimentant une charge 3. Le point M est la masse ou pôle commun des circuits.

Ces composants de puissance 2 de type transistor MOS sont utilisés en particulier dans les contrôleurs de puissance à semi-conducteurs, aussi appelés SSPC (acronyme de leur dénomination anglo-saxonne « Solid State Power Controller »). Ces contrôleurs ont pour but d'alimenter la charge 3 en un courant ayant des caractéristiques de tension et de puissance données. Ces dispositifs permettent de commander l'ouverture de circuits fonctionnant avec des tensions importantes (de 12 à 1000 Volts) et avec des intensités de quelques centaines d'ampères pendant la phase de fermeture ou d'ouverture.

La résistance interne $R_{on}$ à l'état passant du composant de puissance 2 de type transistor MOS, qui est parcourue par le courant I, a été représentée à la Figure 1.

Le dispositif de mesure de courant 1 comprend un étage amplificateur 20 dont l'entrée est reliée à l'une des bornes du composant de puissance 2, l'autre des bornes du composant de puissance 2 étant reliée à la masse M. L'étage amplificateur 20 comprend un amplificateur opérationnel 4 associé à un circuit de réglage de gain comprenant une première résistance R1, une seconde résistance R2 et une résistance variable numérique $R_v$. L'entrée de l'étage amplificateur 20 reliée au composant de puissance 2 correspond à l'entrée non inverseuse $4_1$ de l'amplificateur opérationnel 4.

L'entrée inverseuse $4_2$ de l'amplificateur opérationnel 4 est reliée à la masse M par la première résistance R1 qui est montée en série avec la résistance variable numérique $R_v$.

La seconde résistance R2, qui est une résistance de contre-réaction, est montée entre l'entrée inverseuse $4_2$ et la sortie $4_3$ de l'amplificateur opérationnel 4.

Le dispositif de mesure de courant 1 comprend en outre un calculateur 5, tel qu'un microprocesseur, qui est couplé à un capteur de mesure 6 de la température du composant de puissance 2.

Le calculateur 5 est relié à la résistance variable numérique $R_v$ dont il peut commander sa valeur.

La tension de sortie $V_s$ de l'étage amplificateur 20 (c'est-à-dire, la sortie $4_3$ de l'amplificateur opérationnel 4) est une image du courant I circulant dans le composant de puissance 2.

$$V_S = \left[1 + \frac{R2}{R1 + Rv}\right] R_{on}.I$$

La tension de sortie $V_s$ est égale à : , le gain G de l'amplificateur opérationnel 4 est égal à $\left[1 + \dfrac{R2}{R1 + Rv}\right]$ .

La résistance variable numérique $R_v$ est donc incorporée dans le circuit de réglage de gain de l'étage amplificateur 20. Une modification de cette résistance $R_v$ à l'aide du calculateur 5 permet ainsi de modifier le gain G de l'amplificateur opérationnel 4.

Conformément à l'invention, le calculateur 5 est doté d'un algorithme qui permet de piloter la valeur de la résistance variable numérique $R_v$ en fonction de la résistance interne $R_{on}$ du composant de puissance 2. Cette résistance interne $R_{on}$ varie en fonction de la température du composant de puissance 2.

Le calculateur 5 est spécifiquement configuré pour réaliser les étapes suivantes de compensation de température, de manière itérative : recevoir une valeur de température mesurée en provenance du capteur de température 6 ; corriger la valeur de température mesurée en fonction de la tension de sortie $V_s$ de l'étage amplificateur 20, suivant une première loi incorporée dans le calculateur 5 ; calculer la valeur de la résistance interne $R_{on}$ du composant de puissance 2 en fonction de la valeur de température corrigée, suivant une deuxième loi incorporée dans le calculateur

5 ; calculer la valeur de résistance à appliquer à la résistance variable numérique $R_v$ en fonction de la valeur de $R_{on}$ calculée, suivant une troisième loi incorporée dans le calculateur 5, de façon à ce que le rapport K = Vs/I soit constant sur toute la plage de températures d'utilisation du circuit électrique C, la troisième loi étant $R_v$ = (R1 + R2 - K.R1/$R_{on}$).[$R_{on}$/(K-$R_{on}$)] ; et appliquer le résultat de la valeur de résistance ainsi calculée à la résistance variable numérique $R_v$.

Il est à noter que les première, deuxième et troisième lois pourraient également être remplacées par des tables de valeurs prédéfinies mises en mémoire dans le calculateur 5, sans s'écarter du cadre de la présente invention.

La variation de température du composant de puissance 2 en fonction de la valeur du courant I à ses bornes est ainsi prise en compte et compensée lors du réglage du gain de l'étage amplificateur 20 à l'aide de la résistance variable numérique $R_v$, de manière à réaliser une compensation de température plus précise par rapport à l'état antérieur de la technique.

L'écart de température entre la puce du composant de puissance 2 et son support dans le cas où un fort courant traverse le composant de puissance 2 est ainsi compensé à l'aide de la première loi incorporée dans le calculateur 5, ce qui permet de ne pas sous-estimer la température du composant de puissance 2, et ainsi de ne pas surestimer le courant I traversant le composant de puissance 2.

Le capteur de température 6 peut, par exemple, être un composant du type : thermomètre à résistance de platine (sonde PT100), une thermistance à coefficient de température négatif (CTN), ou un capteur sur liaison série (bus série SPI ou « Synchronous Peripheral Interface »). Selon une première variante de l'invention, la première loi est la suivante : $T_{corrigée}$ = $T_{mesurée}$ + (e.$I^2$ + f) = $T_{mesurée}$ + (e.($V_s$/K)$^2$ + f), où $T_{corrigée}$ est la valeur de température corrigée, $T_{mesurée}$ est la valeur de température mesurée par le capteur de température 6, I est le courant aux bornes du composant de puissance 2, e et f sont des constantes prédéfinies relatives au composant de puissance 2 et à son montage. Les constantes e et f dépendent des caractéristiques thermiques du composant de puissance 2 et du montage de ce dernier sur le support. Ces constantes sont évaluées par des mesures préalables des caractéristiques de température en fonction du courant qui sont opérées sur un montage d'un dispositif complet.

Ainsi, l'augmentation de la température de la puce du composant de puissance 2 par rapport à celle de son support en fonction du courant I traversant le composant de puissance 2 est modélisée à l'aide de la première loi ci-dessus. Les constantes e et f peuvent être déterminées après expérimentation sur le montage du composant de puissance 2.

Selon une seconde variante de l'invention, la première loi est la suivante : $T_{corrigée}$ = $T_{mesurée}$ + [(e.$I^2$ + f).(1 - $e^{(-t/\tau)}$)] = [(e.($V_s$/K)$^2$ + f).(1 - $e^{(-t/\tau)}$)], où $T_{corrigée}$ est la valeur de température corrigée, $T_{mesurée}$ est la valeur de température mesurée par le capteur de température 6, I est le courant I aux bornes du composant de puissance 2, e et f sont des constantes prédéfinies relatives au composant de puissance 2, t représente le temps, et $\tau$ est la constante de temps thermique du dispositif. La constante de temps thermique $\tau$ est celle du dispositif comprenant le composant de puissance 2 associé au support, cette constante de temps $\tau$ étant, elle aussi, évaluée par des mesures préalables des caractéristiques de température en fonction du courant qui sont opérées sur un montage complet.

Dans cette seconde variante, la modélisation est complétée, par rapport à celle de la première variante, par ajout d'un système du premier ordre, de manière à prendre en compte l'évolution de l'erreur de mesure dans le temps.

Ainsi, le calculateur 5 peut associer à toute valeur de la température $T_{mesurée}$ qui est mesurée par le capteur de température 6 une valeur de température corrigée $T_{corrigée}$ qui tient compte de l'écart de température entre le composant de puissance 2 et son support selon la valeur du courant I circulant dans le composant de puissance 2.

Les variations de $R_{on}$ en fonction de la température sont connues car elles font partie des caractéristiques techniques du composant de puissance 2 et sont données par le fournisseur. Elles peuvent être incorporées dans le calculateur 5 sous la forme de la deuxième loi qui est la modélisation polynomiale suivante : $R_{on}$ = a.$T_{corrigée}^2$+b.$T_{corrigée}$+c, où $R_{on}$ est la valeur calculée de la résistance interne à l'état passant du composant de puissance, $T_{corrigée}$ est la valeur de température corrigée, et a, b et c sont des constantes prédéfinies relatives au composant de puissance.

Ainsi, le calculateur 5 peut associer à toute valeur de la température corrigée $T_{corrigée}$ une valeur de la résistance $R_{on}$ du composant de puissance 2.

Le calculateur 5 peut ainsi piloter la valeur de la résistance variable numérique $R_v$ en fonction de la valeur calculée de la résistance interne $R_{on}$ du composant de puissance 2. Il est à noter que la deuxième loi peut être différente d'une loi polynomiale, mais cependant elle doit dépendre de la température et doit être répétable. L'algorithme de pilotage de la résistance variable numérique $R_v$ est tel que le rapport K=$V_s$/I soit constant sur toute la plage de températures d'utilisation du circuit.

Ecrire que le rapport K=$V_s$/I est constant revient à écrire que le produit K=G.$R_{on}$ est également constant. L'introduction de la résistance variable numérique $R_v$ dans l'étage amplificateur 20 permet ainsi de modifier le gain G de l'amplificateur opérationnel 4 et le pilotage par le calculateur 5 est assuré de telle sorte que le produit de ce gain G par la résistance interne $R_{on}$ du composant de puissance 2 reste constant sur la plage de températures d'utilisation souhaitée.

Ainsi, lorsque la résistance $R_{on}$ du composant de puissance 2 est minimale (pour la température minimale), le gain G sera modifié pour avoir sa valeur maximale.

Inversement, lorsque la résistance $R_{on}$ du composant de puissance 2 est maximale (pour la température maximale), le gain G sera modifié pour avoir sa valeur minimale.

La troisième loi est déterminée à la façon suivante :

$$\frac{V_S}{I.R_{on}} = \left[1 + \frac{R2}{R1+Rv}\right] = G \rightarrow Rv = \frac{1}{\frac{V_S}{I.R_{on}} - 1}\left(R1 + R2 - \frac{V_S}{I.R_{on}}R1\right),$$

on obtient ainsi $R_v = (R1 + R2 - K.R1/R_{on}).[R_{on}/(K-R_{on})]$.

Le rapport K étant fixé en fonction du seuil de déclenchement souhaité (par exemple, seuil de détection de court-circuit), la connaissance de la valeur de $R_{on}$ grâce à la valeur corrigée de la température mesurée par le capteur de température 6 permet au calculateur 5 de déterminer à tout moment la valeur à donner à la résistance variable numérique $R_v$.

Le choix des résistances R1 et R2 du circuit de réglage de gain est fait en fonction de la plage de températures d'utilisation envisagée et en fonction de la valeur du rapport K qui est fixée.

La valeur de K est fixée de façon préférée à la valeur du rapport $V_s/I$ correspondant à l'intensité I à laquelle il est nécessaire d'ouvrir le contacteur pour protéger le circuit. La tension $V_s$ correspond alors au seuil de déclenchement d'un circuit 10 qui est un comparateur de tension à référence interne fixée. Ce circuit 10 sera décrit plus en détail par la suite.

Pour tenir compte des dispersions possibles sur la valeur de la résistance interne $R_{on}$ du composant de puissance 2, on pourra dimensionner le dispositif 1 de telle sorte que les valeurs maximale et minimale théoriques pour $R_{on}$ soient :

$$\text{RM = R}_{on}(\text{T}_{corrigée, max}) + 10\% \text{ et Rm = R}_{on}(\text{T}_{corrigée, min}) - 10\%.$$

On notera alors Ra la valeur maximale de $R_v$, et Ri la valeur minimale de $R_v$.

On pourra alors écrire les relations suivantes :

$$\frac{K}{RM} = 1 + \frac{R2}{R1+Ra} \quad \text{et} \quad \frac{K}{Rm} = 1 + \frac{R2}{R1+Ri}.$$

Ce qui permettra de déterminer les valeurs de R1 et R2 :

$$R2 = \left(\frac{K}{RM} - 1\right)(R1 + Ra) \quad \text{avec} \quad R1 = \frac{\left(1 - \frac{K}{Rm}\right)Ri + \left(\frac{K}{RM} - 1\right)Ra}{\frac{K}{Rm} - \frac{K}{RM}}.$$

La tension $V_s$ est l'image du courant I. Elle est appliquée au circuit 10 qui est un circuit comparateur configuré pour provoquer l'ouverture du circuit électrique de puissance C dans lequel le courant I circule lorsque la tension de sortie $V_s$ dépasse un seuil prédéfini $V_L$.

Les fonctions du circuit 10 pourraient également être assurées par le calculateur 5 lui-même, sans s'écarter du cadre de la présente invention.

Le calculateur 5 ne peut être attaqué directement par la tension de sortie $V_s$ de l'étage amplificateur 20. Ainsi, dans le cas où la tension de sortie $V_s$ est supérieure à la valeur maximale pouvant être traitée par le calculateur 5, seulement une partie $V_s'$ de la tension de sortie $V_s$ est appliquée à une entrée 7 du calculateur 5.

Pour cela, la tension de sortie $V_s$ analogique est appliquée au calculateur 5 par l'intermédiaire d'un pont diviseur 8 formé de deux résistances R3 et R4.

Le calculateur 5 incorpore de façon classique un convertisseur analogique/numérique 9 qui possède une tension de référence (ou plage de conversion) notée $V_{ref}$ et une résolution notée n.

La tension numérique $V_{\mu}$ qui est issue de la conversion faite par le convertisseur 9 est ainsi égale à :

$$V_{\mu} = V_s.[R4/(R4 + R3)].[2^n/V_{ref}].$$

Concrètement, avec un convertisseur 9 de résolution 8 bits (n=8), la loi de commande de la valeur de $R_v$ sera du type : $Rv = \dfrac{x}{256}Ra + Ri$ , où Ra est la valeur maximale de $R_v$, Ri est la valeur minimale de $R_v$, et x est un nombre entier inférieur à 255.

Selon la présente invention, afin de prendre en compte l'écart thermique entre la puce du composant de puissance 2 et son support, l'augmentation de la température du composant de puissance 2 liée au courant I est prise en compte pour l'évaluation, par le calculateur 5, de la résistance interne $R_{on}$ du composant de puissance 2.

La température qui est utilisée pour déterminer la valeur de $R_{on}$ est ainsi corrigée en étant augmentée de la valeur déduite à l'aide de la première loi incorporée dans le calculateur 5.

L'algorithme de compensation de température du calculateur 5 est du type récursif, la période de rafraîchissement des données devant être très inférieure à la constante de temps thermique du système. Le procédé de compensation de température selon l'invention peut inclure les étapes préalables suivantes :

1) acquisition de la température $T°_0$ au temps $t_0$ ;
2) calcul de la résistance $R_{on}$ à $T°_0$ ;
3) pilotage du gain (c'est-à-dire, de la résistance variable numérique $R_v$) de l'étage amplificateur 20 en fonction de $R_{on}$ ;
4) acquisition de la tension de sortie $V_{s,0}$ correspondant au courant $I_0$ ;

puis, pour i = 0, ..., n, il peut inclure les étapes suivantes :

5) calcul de l'augmentation de la température $\Delta T_i$ en fonction du courant estimé $I_i$ ;
6) acquisition de la température $T°_{i+1}$ au temps $t_{i+1}$ ;
7) nouvelle estimation de $R_{on}$ à ($T°_{i+1} + \Delta T_i$) ;
8) pilotage du gain de l'étage amplificateur 20 en fonction de $R_{on}$ ;
9) acquisition de la tension de sortie $V_{s,\ i+1}$ correspondant au courant $I_{i+1}$ ;
10) bouclage sur 5).

La mise en oeuvre du procédé de compensation de température selon la présente invention conduit à une minimisation de l'erreur de mesure.

La Figure 2 montre ainsi, à titre d'exemple, le pourcentage d'erreur au cours du temps sur une mesure de courant. Lorsque le procédé selon l'invention n'est pas mis en oeuvre (ce qui correspond au procédé divulgué dans la demande de brevet français FR3034873A1), on remarque (courbe 11) que l'erreur de mesure varie jusqu'à une valeur maximale de 14%.

Grâce au procédé selon la présente invention qui prend en compte l'écart de température entre la puce du composant de puissance 2 et son support, l'erreur de mesure (courbe 12) reste inférieure à 1%. La dispersion de mesure est ainsi divisée par 10.

La description a été faite en référence à un circuit incorporant un composant de puissance 2 de type transistor MOSFET, dont la loi de variation de la résistance interne $R_{on}$ en fonction de la température est monotone (croissante ou décroissante).

L'invention peut aussi être mise en oeuvre en mesurant le courant dans un autre type de composant de puissance 2 dont la résistance varie en fonction de la température d'une façon connue et modélisable et qui n'est pas forcément monotone. Par exemple, un composant de type transistor MOS au carbure de silicium (dont la résistance varie en fonction de la température de façon non monotone) peut être utilisé.

L'essentiel est que le calculateur 5 incorpore une loi ou table modélisant la variation de la résistance interne $R_{on}$ du composant de puissance 2 en fonction de la température et pilote la résistance variable numérique $R_v$ en fonction de cette variation.

L'invention pourrait également être mise en oeuvre avec un autre composant qu'un transistor de puissance et ayant une résistance interne variable en fonction de la température, par exemple un relais ou un contacteur ou encore un câble d'interconnexion dont la longueur serait suffisante pour que sa résistance permette de mesurer une chute de tension à ses bornes.

Il est bien entendu que le mode de réalisation particulier qui vient d'être décrit a été donné à titre indicatif et non limitatif, et que des modifications peuvent être apportées sans que l'on s'écarte pour autant de la présente invention.

**Revendications**

1. Procédé de compensation de température dans un dispositif de mesure de courant (1) comprenant : un composant de puissance (2) configuré pour être incorporé en série dans un circuit électrique de puissance (C) et possédant une résistance interne $R_{on}$ à l'état passant ; un étage amplificateur (20) dont l'entrée est reliée à l'une des bornes du composant de puissance (2), l'étage amplificateur (20) étant configuré de telle sorte que la tension de sortie $V_s$ de l'étage amplificateur (20) est fonction du courant I aux bornes du composant de puissance (2), l'étage amplificateur (20) comprenant un amplificateur opérationnel (4) associé à un circuit de réglage de gain ; et un calculateur (5) couplé à un capteur de température (6) configuré pour mesurer la température du composant de puissance (2) et à une résistance variable numérique $R_v$ du circuit de réglage de gain de l'étage amplificateur (20), le calculateur (5) étant configuré pour réaliser les étapes suivantes de manière itérative :

   - recevoir une valeur de température mesurée en provenance du capteur de température (6) ;
   - corriger la valeur de température mesurée en fonction de la tension de sortie $V_s$ de l'étage amplificateur (20), suivant une première loi ou table incorporée dans le calculateur (5) ;
   - calculer la valeur de la résistance interne $R_{on}$ du composant de puissance (2) en fonction de la valeur de température corrigée, suivant une deuxième loi ou table incorporée dans le calculateur (5) ;
   - calculer la valeur de résistance à appliquer à la résistance variable numérique $R_v$ en fonction de la valeur de $R_{on}$ calculée, suivant une troisième loi ou table incorporée dans le calculateur (5), de façon à ce que le rapport $K = V_s/I$ soit constant sur toute la plage de températures d'utilisation du circuit électrique (C) ; et
   - appliquer la valeur de résistance calculée à la résistance variable numérique $R_v$.

2. Procédé selon la revendication 1, **caractérisé par le fait que** la première loi est la suivante : $T_{corrigée} = T_{mesurée} + (e. I^2 + f) = T_{mesurée} + (e. (V_s/K)^2 + f)$, où $T_{corrigée}$ est la valeur de température corrigée, $T_{mesurée}$ est la valeur de température mesurée par le capteur de température (6), I est le courant aux bornes du composant de puissance (2), e et f sont des constantes prédéfinies relatives au composant de puissance (2) et à son montage.

3. Procédé selon la revendication 1, **caractérisé par le fait que** la première loi est la suivante : $T_{corrigée} = T_{mesurée} + [(e.I^2 + f) . (1 - e^{(-t/\tau)})] = [(e. (V_s/K)^2 + f) . (1 - e^{(-t/\tau)})]$, où $T_{corrigée}$ est la valeur de température corrigée, $T_{mesurée}$ est la valeur de température mesurée par le capteur de température (6), I est le courant aux bornes du composant de puissance (2), e et f sont des constantes prédéfinies relatives au composant de puissance (2) et à son montage, t représente le temps, et $\tau$ est la constante de temps thermique du dispositif.

4. Procédé selon l'une des revendications 1 à 3, **caractérisé par le fait que** la deuxième loi est la suivante : $R_{on} = a.T_{corrigée}^2 + b.T_{corrigée} + c$, où $R_{on}$ est la valeur calculée de la résistance interne à l'état passant du composant de puissance (2), $T_{corrigée}$ est la valeur de température corrigée, et a, b et c sont des constantes prédéfinies relatives au composant de puissance (2).

5. Procédé selon l'une des revendications 1 à 4, **caractérisé par le fait que** le circuit de réglage de gain comprend la résistance variable numérique $R_v$, une première résistance R1 disposée entre la résistance variable numérique $R_v$ et l'entrée inverseuse ($4_2$) de l'amplificateur opérationnel (4), et une seconde résistance R2 disposée entre l'entrée inverseuse ($4_2$) et la sortie ($4_3$) de l'amplificateur opérationnel (4), la troisième loi étant la suivante : $R_v = (R1 + R2 - K.R1/R_{on}) . [R_{on}/(K-R_{on})]$.

6. Procédé selon l'une des revendications 1 à 5, **caractérisé par le fait que** la tension de sortie $V_s$ analogique de l'étage amplificateur (20) est convertie en une valeur numérique $V_\mu$ par le calculateur (5) auquel la tension de sortie $V_s$ est appliquée par l'intermédiaire d'un pont diviseur (8) formé de deux résistances R3 et R4, la tension $V_\mu$ numérique convertie par un convertisseur analogique/numérique (9) incorporé au calculateur (5) étant ainsi égale à : $V_\mu = V_s. [R4/(R4 + R3)].[2^n/V_{ref}]$, où $V_{ref}$ est la tension de référence du convertisseur analogique/numérique (9), et n est la résolution de ce convertisseur (9).

7. Dispositif de mesure de courant (1) comprenant un composant de puissance (2) configuré pour être incorporé en série dans un circuit électrique de puissance (C) et possédant une résistance interne $R_{on}$ à l'état passant ; un étage amplificateur (20) dont l'entrée est reliée à l'une des bornes du composant de puissance (2), l'étage amplificateur (20) étant configuré de telle sorte que la tension de sortie $V_s$ de l'étage amplificateur (20) est fonction du courant I aux bornes du composant de puissance (2), l'étage amplificateur (20) comprenant un amplificateur opérationnel (4)

associé à un circuit de réglage de gain ; et un calculateur (5) couplé à un capteur de température (6) configuré pour mesurer la température du composant de puissance (2) et à une résistance variable numérique $R_v$ du circuit de réglage de gain de l'étage amplificateur (20), le calculateur (5) étant configuré pour mettre en oeuvre le procédé de compensation de température selon l'une des revendications 1 à 6.

8. Dispositif de mesure de courant (1) selon la revendication 7, **caractérisé par le fait que** le composant de puissance (2) est l'un parmi un transistor MOS, un transistor bipolaire et un transistor bipolaire à grille isolée, IGBT.

9. Dispositif de mesure de courant (1) selon l'une des revendications 7 et 8, **caractérisé par le fait qu'**il comprend en outre un circuit comparateur (10) auquel est appliquée la tension de sortie $V_s$ de l'étage amplificateur (20), ledit circuit comparateur (10) étant configuré pour provoquer l'ouverture du circuit électrique de puissance (C) dans lequel le courant I circule lorsque la tension de sortie $V_s$ dépasse un seuil prédéfini $V_L$.

**Patentansprüche**

1. - Verfahren zur Temperaturkompensation in einer Strommessvorrichtung (1), umfassend: eine Leistungskomponente (2), die konfiguriert ist, um in Reihe in eine elektrische Leistungsschaltung (C) integriert zu sein und einen internen Widerstand $R_{on}$ im eingeschalteten Zustand besitzt; eine Verstärkerstufe (20), deren Eingang mit einem der Anschlüsse der Leistungskomponente (2) verbunden ist, wobei die Verstärkerstufe (20) konfiguriert ist, sodass die Ausgangsspannung $V_s$ der Verstärkerstufe (20) von dem Strom I an den Anschlüssen der Leistungskomponente (2) abhängig ist, wobei die Verstärkerstufe (20) einen Betriebsverstärker (4) umfasst, der mit einer Verstärkungsregelungsschaltung assoziiert ist; und einen Rechner (5), der mit einem Temperatursensor (6), der konfiguriert ist, um die Temperatur der Leistungskomponente (2) zu messen, und mit einem digitalen variablen Widerstand $R_v$ der Verstärkungsregelungsschaltung der Verstärkerstufe (20) gekoppelt ist, wobei der Rechner (5) konfiguriert ist, um die folgenden Schritte iterativ auszuführen:

   - Empfangen eines gemessenen Temperaturwerts von dem Temperatursensor (6);
   - Korrigieren des gemessenen Temperaturwerts abhängig von der Ausgangsspannung $V_s$ der Verstärkerstufe (20) gemäß einem ersten Gesetz oder einer ersten Tabelle, der/die in den Rechner (5) integriert ist;
   - Berechnen des Werts des internen Widerstands $R_{on}$ der Leistungskomponente (2) abhängig von dem korrigierten Temperaturwert gemäß einem zweiten Gesetz oder einer zweiten Tabelle, der/die in den Rechner (5) integriert ist;
   - Berechnen des Widerstandswerts, der auf den digitalen variablen Widerstand $R_v$ anzuwenden ist, abhängig von dem berechneten Wert von $R_{on}$, gemäß einem dritten Gesetz oder einer Tabelle, der/die in den Rechner (5) integriert ist, sodass das Verhältnis $K = V_s/I$ über den gesamten Bereich der Gebrauchstemperaturen der elektrischen Schaltung (C) konstant ist; und
   - Anwenden des berechneten Widerstandswerts auf den numerisch variablen Widerstand $R_v$.

2. - Verfahren nach Anspruch 1, **dadurch gekennzeichnet, dass** das erste Gesetz wie folgt ist: $T_{korrigiert} = T_{gemessen} + (e.I^2 + f) = T_{gemessen} + (e. (V_s/K)^2 + f)$, wobei $T_{korrigiert}$ der korrigierte Temperaturwert ist, $T_{gemessen}$ der von dem Temperatursensor (6) gemessene Temperaturwert ist, I der Strom an den Anschlüssen der Leistungskomponente (2) ist, e und f vordefinierte Konstanten sind, die sich auf die Leistungskomponente (2) und ihre Montage beziehen.

3. - Verfahren nach Anspruch 1, **dadurch gekennzeichnet, dass** das erste Gesetz wie folgt ist: $T_{korrigiert} = T_{gemessen} + [(e.I^2 + f).(1 - e^{(-t/\tau)})] = [(e.(V_s/K)^2 + f).(1 - e^{(-t/\tau)})]$, wobei $T_{korrigiert}$ der korrigierte Temperaturwert ist, $T_{gemessen}$ der von dem Temperatursensor (6) gemessene Temperaturwert ist, I der Strom an den Anschlüssen der Leistungskomponente (2) ist, e und f vordefinierte Konstanten sind, die sich auf die Leistungskomponente (2) und ihre Montage beziehen, t die Zeit darstellt und T die thermische Zeitkonstante der Vorrichtung ist.

4. - Verfahren nach einem der Ansprüche 1 bis 3, **dadurch gekennzeichnet, dass** das zweite Gesetz wie folgt ist: $R_{on} = a.T_{korrigiert}^2 + b.T_{korrigiert} + c$, wobei $R_{0n}$ der berechnete Wert des internen Widerstands in eingeschaltetem Zustand der Leistungskomponente (2) ist, $T_{korrigiert}$ der korrigierte Temperaturwert ist und a, b und c vordefinierte Konstanten sind, die sich auf die Leistungskomponente (2) beziehen.

5. - Verfahren nach einem der Ansprüche 1 bis 4, **dadurch gekennzeichnet, dass** die Verstärkungsregelungsschaltung den digitalen variablen Widerstand $R_v$, einen ersten Widerstand R1, der zwischen dem digitalen variablen Widerstand $R_v$ und dem invertierenden Eingang ($4_2$) des Betriebsverstärkers (4) angeordnet ist, und einen zweiten Widerstand R2, der zwischen dem invertierenden Eingang ($4_2$) und dem Ausgang ($4_3$) des Betriebsverstärkers (4) angeordnet ist, umfasst, wobei das dritte Gesetz wie folgt ist: $R_v$ = (R1 + R2 -K.R1/$R_{on}$).[$R_{on}$/(K-$R_{on}$)].

6. - Verfahren nach einem der Ansprüche 1 bis 5, **dadurch gekennzeichnet, dass** die analoge Ausgangsspannung $V_s$ der Verstärkerstufe (20) durch den Rechner (5), an den die Ausgangsspannung $V_s$ über eine aus zwei Widerständen R3 und R4 gebildete Teilerbrücke (8) angelegt wird, in einen digitalen Wert $V_\mu$ umgewandelt wird, wobei die durch einen in den Rechner (5) integrierten Analog/Digital-Wandler (9) umgewandelte digitale Spannung $V_\mu$ somit gleich ist wie: $V_\mu$ = $V_s$. [R4/ (R4 + R3)].[$2^n$/$V_{ref}$], wobei $V_{ref}$ die Referenzspannung des Analog-Digital-Wandlers (9) ist und n die Auflösung dieses Wandlers (9) ist.

7. - Strommessvorrichtung (1), umfassend eine Leistungskomponente (2), die konfiguriert ist, um in Reihe in eine elektrische Leistungsschaltung (C) integriert zu sein und einen internen Widerstand $R_{on}$ im eingeschalteten Zustand besitzt; eine Verstärkerstufe (20), deren Eingang mit einem der Anschlüsse der Leistungskomponente (2) verbunden ist, wobei die Verstärkerstufe (20) konfiguriert ist, sodass die Ausgangsspannung $V_s$ der Verstärkerstufe (20) von dem Strom I an den Anschlüssen der Leistungskomponente (2) abhängig ist, wobei die Verstärkerstufe (20) einen Betriebsverstärker (4) umfasst, der mit einer Verstärkungsregelungsschaltung assoziiert ist; und einen Rechner (5), der mit einem Temperatursensor (6), der konfiguriert ist, um die Temperatur der Leistungskomponente (2) zu messen, und mit einem digitalen variablen Widerstand $R_v$ der Verstärkungsregelungsschaltung der Verstärkerstufe (20) gekoppelt ist, wobei der Rechner (5) konfiguriert ist, um das Verfahren zur Temperaturkompensation nach einem der Ansprüche 1 bis 6 auszuführen.

8. - Strommessvorrichtung (1) nach Anspruch 7, **dadurch gekennzeichnet, dass** die Leistungskomponente (2) eines von einem MOS-Transistor, einem Bipolartransistor und einem Bipolartransistor mit isoliertem Gate, IGBT, ist.

9. - Strommessvorrichtung (1) nach einem der Ansprüche 7 oder 8, **dadurch gekennzeichnet, dass** sie ferner eine Komparatorschaltung (10) umfasst, an die die Ausgangsspannung $V_s$ der Verstärkerstufe (20) angelegt wird, wobei die Komparatorschaltung (10) konfiguriert ist, um das Öffnen der elektrischen Leistungsschaltung (C), in dem der Strom I fließt, zu bewirken, wenn die Ausgangsspannung $V_s$ einen vordefinierten Schwellenwert $V_L$ überschreitet.

## Claims

1. - A temperature compensation method in a current measuring device (1) comprising: a power component (2) configured to be incorporated in series in an electric power circuit (C) and having an internal resistance $R_{on}$ in the on state; an amplifier stage (20) whose input is connected to one of the terminals of the power component (2), the amplifier stage (20) being configured such that the output voltage $V_s$ of the amplifier stage (20) is a function of the current I at the terminals of the power component (2), the amplifier stage (20) comprising an operational amplifier (4) associated with a gain adjustment circuit; and a calculator (5) coupled to a temperature sensor (6) configured to measure the temperature of the power component (2) and to a digital variable resistor $R_v$ of the gain adjustment circuit of the amplifier stage (20), the calculator (5) being configured to carry out the following steps iteratively:

   - receiving a measured temperature value originating from the temperature sensor (6);
   - correcting the measured temperature value as a function of the output voltage $V_s$ of the amplifier stage (20), according to a first law or table incorporated into the calculator (5);
   - calculating the value of the internal resistance $R_{on}$ of the power component (2) as a function of the corrected temperature value, according to a second law or table incorporated into the calculator (5);
   - calculating the resistance value to be applied to the digital variable resistor $R_v$ as a function of the calculated value of $R_{on}$, according to a third law or table incorporated into the calculator (5), such that the ratio K = Vs/I is constant over the entire usage temperature range of the electric circuit (C); and
   - applying the calculated resistance value to the digital variable resistor $R_v$.

2. - The method according to claim 1, **characterized in that** the first law is as follows: $T_{corrected}$ = $T_{measured}$ + (e.$I^2$ + f) = $T_{measured}$ + (e.$(V_s/K)^2$ + f),
   where $T_{corrected}$ is the corrected temperature value, $T_{measured}$ is the temperature value measured by the temperature sensor (6), I is the current at the terminals of the power component (2), e and f are predefined constants relative to the power component (2) and its assembly.

3. - The method according to claim 1, **characterized in that** the first law is as follows: $T_{corrected}$ = $T_{measured}$ + [(e.$I^2$ +

f).(1-e$^{(-t/T)}$)] = [(e.(V$_s$/K)$^2$ + f).(1-e$^{(-t/T)}$)],

where T$_{corrected}$ is the corrected temperature value, T$_{measured}$ is the temperature value measured by the temperature sensor (6), I is the current at the terminals of the power component (2), e and f are predefined constants relative to the power component (2) and its assembly, t represents the time, and $\tau$ is the thermal time constant of the device.

4. - The method according to one of claims 1 to 3, **characterized in that** the second law is as follows: R$_{on}$ = a.T$_{corrected}$$^2$+b.T$_{corrected}$+c, where R$_{on}$ is the calculated value of the internal resistance in the on state of the power component (2), T$_{corrected}$ is the corrected temperature value, and a, b and c are predefined constants relative to the power component (2).

5. - The method according to one of claims 1 to 4, **characterized in that** the gain adjustment circuit comprises the digital variable resistor R$_v$, a first resistor R1 placed between the digital variable resistor R$_v$ and the inverting input (4$_2$) of the operational amplifier (4), and a second resistor R2 placed between the inverting input (4$_2$) and the output (4$_3$) of the operational amplifier (4), the third law being as follows: R$_v$ = (R1 + R2 - K.R1/R$_{on}$) .[R$_{on}$/(K-R$_{on}$)].

6. - The method according to one of claims 1 to 5, **characterized in that** the analog output voltage V$_s$ of the amplifier stage (20) is converted into a digital value V$_\mu$ by the calculator (5) to which the output voltage V$_s$ is applied by means of a divider bridge (8) formed by two resistors R3 and R4, the digital voltage V$_\mu$ converted by an analog/digital converter (9) incorporated into the calculator (5) thus being equal to: V$_\mu$ = V$_s$. [R4/(R4 + R3)]. [2$^n$/V$_{ref}$], where V$_{ref}$ is the reference voltage of the analog/digital converter (9), and n is the resolution of this converter (9).

7. - A current measuring device (1) comprising a power component (2) configured to be incorporated in series into an electric power circuit (C) and having an internal resistance R$_{on}$ in the on state; an amplifier stage (20) whose input is connected to one of the terminals of the power component (2), the amplifier stage (20) being configured such that the output voltage V$_s$ of the amplifier stage (20) is a function of the current I at the terminals of the power component (2), the amplifier stage (20) comprising an operational amplifier (4) associated with a gain adjustment circuit; and a calculator (5) coupled to a temperature sensor (6) configured to measure the temperature of the power component (2) and to a digital variable resistor R$_v$ of the gain adjustment circuit of the amplifier stage (20), the calculator (5) being configured to implement the temperature compensation method according to one of claims 1 to 6.

8. - The current measuring device (1) according to claim 7, **characterized in that** the power component (2) is chosen among a MOS transistor, a bipolar transistor and an insulated-gate bipolar transistor, IGBT.

9. - The current measuring device (1) according to one of claims 7 and 8, **characterized in that** it further comprises a comparator circuit (10) to which the output voltage V$_s$ of the amplifier stage (20) is applied, said comparator circuit (10) being configured to cause the opening of the electric power circuit (C) in which the current I circulates when the output voltage V$_s$ exceeds a predefined threshold V$_L$.

[Fig. 1]

Fig. 1

[Fig. 2]

Fig. 2

**EP 3 916 400 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3034873 A1
- EP 3086131 A1

- JP 2012154829 A